# EUROPÄISCHE PATENTSCHRIFT

(11) **EP 0 912 649 B1**
(45) Veröffentlichungstag und Bekanntmachung des Hinweises auf die Patenterteilung: **17.12.2003**
(21) Anmeldenummer: 97935433.9
(22) Anmeldetag: 17.07.1997
(51) Int. Cl.: C09J 163/00, C08G 59/62

(54) **THERMISH HÄRTBARES EINKOMPONENTIGES LVA(=LOW VISKOSITY ADHESIVE)-KLEBSTOFFSYSTEM FÜR VERKLEBUNGEN IM MIKROBEREICH**
HEAT-SETTING SINGLE-COMPONENT LVA (LOW-VISCOSITY ADHESIVE) SYSTEM FOR BONDING IN THE MICRO-RANGE
SYSTEME D'ADHESIF DE FAIBLE VISCOSITE A UN COMPOSANT DURCISSABLE THERMIQUEMENT A PROPRIETES DE STOCKAGE AMELIOREES

(30) Priorität: 18.07.1996 DE 19629082
(43) Veröffentlichungstag der Anmeldung: 06.05.1999
(73) Patentinhaber: SIEMENS AKTIENGESELLSCHAFT, 80333 München (DE)
(72) Erfinder: HOEHN, Klaus, D-82024 Taufkirchen (DE); BAYER, Heiner, D-82140 Olching (DE); HONSBERG-RIEDL, Martin, D-83435 Bad Reichenhall (DE)
(86) Internationale Anmeldenummer: DE9701505
(87) Internationale Veröffentlichungsnummer: WO98003606

(56) Entgegenhaltungen:
- EP-A- 0 527 107
- DE-A- 3 008 497
- US-A- 4 480 059

## Beschreibung

Die Erfindung betrifft ein Gießharzsystem, das zur Bildung von Verklebungen mit Maßtoleranzen im µm- und Sub-µm-Bereich geeignet ist.

Für Mikroverklebungen sind Klebstoffsysteme bekannt, die im allgemeinen aus einer Harz- und einer Härterkomponente bestehen. Diese zweikomponentigen Klebstoffsysteme bereiten in den kleinen Mengen, in denen sie für die Verklebungen im Mikrobereich benötigt werden, Probleme. Insbesondere beim exakten Dosieren, Mischen und Homogenisieren der einzelnen Komponenten direkt vor der Applikation. Ein Nachteil ist auch, daß sie üblicherweise eine zu hohe Viskosität haben und deshalb erst bei höheren Temperaturen (ca. 70 °C) so dünnflüssig sind, daß der Klebstoffauftrag für die Mikrodosierung - so genannte LVA (Low Viskosity Adhesives)-Klebstoffe- erfolgen kann. Die bekannten 2-komponentigen Systeme haben außerdem den Nachteil, daß sie wegen ihrer Inhomogenitäten in dünnen Schichten oder kleinen Tropfen selbst in einer Inertgas- oder Stickstoffatmosphäre nur unvollständig aushärten. All diese Faktoren haben zur Folge, daß es bisher nicht möglich ist, für die industrielle Fertigung in geforderter, reproduzierbarer Qualität technisch verwertbare Verbunde hinsichtlich Verbundfestigkeit und Maßtoleranz im µm- und Sub-µm-Bereich (= kleiner 1µm) zu realisieren.

Es besteht deshalb der Bedarf an einem Klebstoffsystem, das eine rationelle, automatisierte, sichere und kostengünstige Verbindungstechnik für low-cost-Systeme der Elektronik und Optoelektronik ermöglicht. Insbesondere besteht ein Bedarf an Klebstoffsystemen für das Kleben im µm-Bereich und Sub-µm-Bereich, die in extrem dünnen Schichten oder kleinen Tropfen Aufgabe der vorliegenden Erfindung ist es daher, ein Klebstoffsystem zur Verfügung zu stellen, das auch in kleinen Mengen keine Inhomogenitäten aufweist und für die Mikromengendosierung geeignet ist. Weiterhin ist es Aufgabe der vorliegenden Erfindung, ein Klebstoffsystem zur Verfügung zu stellen, das in dünnen Schichten vollständig aushärtet. Dadurch werden die Zuverlässigkeit und die Festigkeit des Klebeverbunds erhöht und unerwünschte Ausgasungen des fertigen Klebeverbunds können reduziert werden. Schließlich soll das erfindungsgemäße Klebstoffsystem eine, im Vergleich zu den bekannten Systemen, niedrigere Viskosität und ausgewogene Verlaufseigenschaften zeigen. Zuletzt sollte die Gebrauchsdauer der Klebstoffsysteme das Fügen der einzelnen Bauelemente mit Maßtoleranzen im Mikrobereich und darunter erlauben.

Diese Aufgaben werden durch das erfindungsgemäße Klebstoffsystem gelöst. Gegenstand der vorliegenden Erfindung ist ein thermisch härtbares, einkomponentiges Klebstoffsystem, das folgende Bestandteile umfaßt:
60 - 98 Gew% eines Epoxidgießharzes
2 - 30 Gew% eines mehrwertigen Alkohols oder Zuckers,
0,2 - 2,0 Gew% S-Benzylthiolaniumhexafluoroantimonat als thermischen Initiator,
0,2 - 2,0 Gew% eines Haftvermittlers und/oder
0 - 3,0 Gew% eines Verlaufshilfsmittels und/oder
0 - 4 Gew% eines Thixotropiermittels und/oder eines Fließmodifikators..

Außerdem ist die Verwendung eines derartigen Klebstoffsystems zur Bildung von Verklebungen mit Maßtoleranzen im µm- und Sub-µm-Bereich Gegenstand der vorliegenden Erfindung. Weitere vorteilhafte Ausgestaltungen ergeben sich aus der Beschreibung sowie dem Ausführungsbeispiel und aus den Unteransprüchen.

Als "thermisch härtbare Klebstoffsysteme" im Sinne der vorliegenden Erfindung werden thermisch härtbare Harzsysteme und Reaktionsharze verstanden, die so niederviskos sind, daß sie durch Gießen in eine entsprechende Form gebracht werden können, in der sie dann thermisch, d. h. durch Temperaturerhöhung bei Vorhandensein von geeigneten Additiven (Initiatoren, Beschleuniger, andere Komponenten) aushärtbar sind.

Das Epoxidgießharz ist in der erfindungsgemäßen Formulierung in einer Menge von 60 - 98 Gew% enthalten, vorteilhafterweise in einer Menge von 75 bis 95 Gew%, vorzugsweise zwischen 80 und 95 Gew% und besonders bevorzugt im Bereich zwischen 85 und 93 Gew%.

Als "Epoxidgießharz" können cyclo-aliphatische Epoxidharze wie beispielsweise das Harz CY177 von Ciba Geigy (ein 3,4-Epoxycyclohexylmethyl)-adipat oder das Harz CY179 ebenfalls von Ciba Geigy (ein 3,4-Epoxy-cycle-hexylmethyl-3',4'-epoxycyclo-hexancarboxylat) eingesetzt werden. Außerdem sind lineare aliphatische Epoxidharze z. B. epoxidiertes Polybutadien oder epoxidiertes Sojabohnenöl geeignet. Ebenso geeignet sind andere kationisch härtende Harze wie Vinylether oder Vinylaromaten. Außerdem sind Epoxidharze vom Glycidylether-Typ geeignet. Als Basis für die Glycidylether können dienen: Bisphenole, z. B. Bisphenol A, Di- oder Polyhydroxyaromaten, z. B. Resorcin, Polyarylalkyle mit phenolischen OH-Gruppen, Novolake, Polyalkylenglykole oder auch Mehrfachalkohole, z. B. Glycerin oder Pentaerythritol. Weiterhin geeignet sind Verbindungen von Glycidylether-Ester-Typ, z. B. Para-Hydroxybenzoesäure-Glycidyletherester; reine Glycidylester von Mehrfachcarbonsäuren mit aliphatischem oder aromatischem Kern, z.B. Hexahydrophthalsäure oder Phthalsäure.

Als "Alkohole oder Zucker" werden erfindungsgemäß mehrwertige Alkohole mit 1-15 Hydroxygruppen oder Zucker eingesetzt. Bevorzugt werden mehrwertige Alkohole mit 1 bis 5 Hydroxygruppen verwendet. Das Grundgerüst des Alkohols oder Zuckers kann dabei beliebig variieren, es kann aliphatisch, cyclisch oder bicyclisch sein, es kann lediglich aus Einfachbindungen oder auch aus Mehrfachbindungen bestehen und es kann sich auch um ein aromatisches System handeln. Bevorzugt eingesetzt wird u. a. der TCD-Alkohol DM von der Fa. Hoechst, ein 3(4),8(9)Bis(hydroxymethyl)tricyclo[5.2.1.0^{2,6}]decan. Der mehrwertige Alkohol ist in der Klebstofformulierung mit einem Masseanteil zwischen 2 und 30 Gew% enthalten. Bevorzugt hat er einen Masseanteil zwischen 2,5 und 20 Gew%, besonders bevorzugt einen Anteil zwischen 4,5 und 12 Gew%.

Als thermischer Initiator wird S-Benzylthiolaniumhexafluoroantimonat verwendet.

Als Haftvermittler wird A187 von der Fa. Hüls, ein 3-Glycidyloxypropyltrimethoxysilan verwendet.

Als Verlaufshilfsmittel kann Modaflow (Fa. Monsanto)und als Fließmodifikatoren oder Thixotropiermittel können beispielsweise die kommerziell verfügbaren Aerosil-Typen der Fa. Degussa verwendet werden.

Neben den bereits angeführten Bestandteilen können im erfindungsgemäßen Klebstoffsystem noch weitere, an sich bekannte Zusätze und Additive enthalten sein. Dadurch können die Klebstoffsysteme auch zusätzliche Eigenschaften erhalten, wie besondere Farbe oder auch Transparenz, sowie Schwerentflammbarkeit oder Temperaturbeständigkeit. Zusätze in diesem Sinne können deshalb beispielsweise Farbstoffe, Pigmente, Fließmodifikatoren, allgemein Stabilisatoren, Flammschutzmittel oder mineralische oder andere Füllstoffe sein. Dabei ist es fast immer möglich, bestimmte Eigenschaften durch Zusätze zu erzielen, beispielsweise selektive Absorption oder Transparenz durch einen Farbstoff.

Bei der Herstellung des Klebstoffsystems wird wie bei vergleichbaren Systemen vorgegangen. Die Formulierungsbestandteile, wie das Epoxidharz, der mehrwertige Alkohol, der thermische Initiator, der Haftvermittler und ggf. ein Verlaufshilfsmittel werden, ggf. auch unter erhöhten Temperaturen und mit wieder entfernbarem Lösungsmittel, gleichmäßig ineinander gemischt. Für die Herstellung des Klebstoffsystems kann also auf übliche, dem Stand der Technik vertraute Methoden zurückgegriffen werden.

Im folgenden wird die Erfindung anhand eines Ausführungsbeispiels noch näher erläutert. Tabelle 1 zeigt die Formulierungsbestandteile eines repäsentativen Klebstoffsystems.

**Tabelle 1:**

| Bestandteile und chemische Bezeichnung einer repäsentativen Formulierung | |
|---|---|
| Bestandteil (Bezugsquelle), chemische Bezeichnung | Anteil [Masseteile] |
| **Harz:** CY177 (Ciba Geigy), Bis(3,4-Epoxycyclohexylmethyl)-adipat | 100 |
| **mehrwertiger Alkohol:** TCD-Alkohol DM (Hoechst), 3(4),8(9)-Bis(hydroxymethyl)-tricyclo [5.2.1.0^{2,6}]decan | 10 |
| **thermischer Initiator:** S-Benzylthiolaniumhexafluoroantimonat (Aldrich) | 1 |
| **Haftvermittler:** A187 (Hüls) 3-Glycidyloxypropyltrimethoxysilan | 0,5 |

In Tabelle 2 sind ausgewählte Werkstoffcharakteristika der im Beispiel genannten Formulierung zusammengefaßt.

**Tabelle 2:**

| Kenndaten zur Verarbeitung sowie ausgewählte Werkstoffcharakteristika des vernetzten Klebstoffs | |
|---|---|
| Härtung | 1 h 120 °C (vollständige Aushärtung) |
| Harzeigenschaften: Viskosität η [mPas] | |
| Raumtemperatur | 880 |
| 60 °C | 120 |
| 80 °C | 80 |
| | |
| Reaktivität: 2η (80°C) [min] | 55 |
| | |
| DSC (10 K/min): | |
| T(Onset) [°C] | 96 |
| T(min) [°C] | 130 |
| Wärmetönung ΔH_{R} [-J/g] | 415 |
| Formstoffeigenschaften: Glasübergangstemperatur [°C] (DSC, 10 K/min) | 68 |
| | |
| Dynamisch-mechanische Analyse (Zugmodus, 3 K/min) | |
| E-Modul(20°C) [N/mm²] | 2.400 |
| α(-60 bis 40°C) [ppm/K] | 96 |
| α-Übergang [°C] | 63 |
| β-Übergang [°C] | -64 |
| | |
| Shore Härte | D 81 |
| | |
| Thermische Stabilität: TG/DTA (10 K/min), N₂) | |
| 5 % Masseverlust [°C] | 350,4 |
| DTG (max) [°C] | 413,4 |
| Abbaurate [%/min] | 22,7 |

Tabelle 3 zeigt Untersuchungen zur Lagerbarkeit der Formulierungen. Es wurden 2 Monate als Beobachtungszeitraum festgelegt und dabei traten bei der Kühlschranklagerung (5 -8°C) keinerlei Unverträglichkeiten bzw. Entmischungen auf, wie beispielsweise das Auskristallisieren des thermischen Initiators wäre.

**Tabelle 3:**

| Viskositätsverlauf η(t) bei verschiedenen Lagertemperaturen | | |
|---|---|---|
| Lagerzeit [d] | bei Raumtemperatur η (60°C) [mPas] | bei 7°C η (60°C) [mPas] |
| 0 | 120 | 120 |
| 60 | 2.200 | 120 |

Mit dem erfindungsgemäßen Klebstoffsystem ist eine automatisierte und sichere Mikroverklebung elektronischer und optoelektronischer Komponenten im µm- und Sub-µm-Bereich möglich. Das erfindungsgemäße 1-komponentige Epoxidgießharz härtet nicht sofort an, so daß das Fügen der einzelnen Bauelemente bis zur endgültigen Fixierung erlaubt ist. Die Epoxidharzkomponente sowie das gesamte Klebstoffsystem ist niederviskos genug, um bei Mikroverklebungen verwendet zu werden. Schließlich können mit dem Alkohol oder Zucker, insbesondere mit einem mehrwertigen Alkohol, die Abtropf-, die Benetzungs- und die Fließeigenschaften des Klebstoffsystems sowie das mechanische Verhalten des Klebstoffverbundes eingestellt werden.

Das Klebstoffsystem ist problemlos in Mikromengen zu dosieren und läßt sich hinsichtlich des Abtropf- Benetzungs- und Verlaufsverhaltens noch durch die Zugabe von Verlaufshilfsmittel optimieren. Durch Wärmebeaufschlagung, d. h., durch lokale Erwärmung oder Erwärmung der zu verbindenden Teile vernetzt das Klebstoffsystem rasch zu einem homogenen Klebeverbund.

Die eingangs erwähnten Nachteile der bekannten zweikomponentigen Klebstofformulierungen für die Mikroverbindungstechnik sind dadurch überwunden. Insbesondere werden die Dosierbarkeit und die Dosiergenauigkeit verbessert, sowie unvollständige Mischung und Mischungsfehler vermieden und die Viskosität erniedrigt.

Die Erfindung betrifft ein einkomponentiges Klebstoffsystem, das zumindest aus einem Gießharz, insbesondere einem Epoxidgießharz, und einem mehrwertigem Alkohol besteht. Das niedrigviskose Klebstoffsystem ist mikrodosierbar, lagerstabil, vollständig aushärtbar und geeignet für Applikationen, bei denen die Maßtoleranzen im µm- und Sub-µm-Bereich liegen.

## Patentansprüche

1. Thermisch härtbares, einkomponentiges Klebstoffsystem, das folgende Bestandteile umfaßt:
60 - 98 Gew% eines Epoxidgießharzes
2 - 30 Gew% eines mehrwertigen Alkohols oder Zuckers,
0,2 - 2,0 Gew% S-Benzylthiolaniumhexafluoroantimonat als thermischer Initiator,
0,2 - 2,0 Gew% eines Haftvermittlers und/oder
0 - 3,0 Gew% eines Verlaufshilfsmittels und/oder
0 - 4 Gew% eines Thixotropiermittels und/oder eines Fließmodifikators.

2. Klebstoffsystem nach Anspruch 1, das folgende Bestandteile umfaßt:
85 - 93 Gew% eines Epoxidgießharzes,
4,5 - 12 Gew% eines mehrwertigen Alkohols,
0,7 - 1,0 Gew% S-Benzylthiolaniumhexafluoroantimonat und
0,3 - 0,6 Gew% eines Haftvermittlers und/oder
0 - 1,5 Gew% eines Verlaufshilfsmittels und/oder
0 - 2,0 Gew% eines Thixotropiermittels und/oder eines Fließmodifikators.

3. Klebstoffsystem nach Anspruch 1 oder 2, bei dem das Epoxidharz, Bis(3,4-Epoxycyclohexylmethyl)-adipat und der mehrwertige Alkohol 3(4),8(9)-Bis(hydroxymethyl)-tricyclo[5.2.1.0^{2,6}]decan ist.

4. Verwendung des Klebstoffsystems nach einem der vorstehenden Ansprüche zur Bildung von Verklebungen mit Maßtoleranzen im µm- und Sub-µm-Bereich.

## Claims

1. A thermally curable single-component adhesive system comprising:
60-98% by weight of an epoxy casting resin,
2-30% by weight of a polyhydric alcohol or sugar,
0.2-2.0% by weight of an S-benzylthiolanium hexafluoroantimonate thermal initiator,
0.2-2.0% by weight of an adhesion promoter and/or
0-3.0% by weight of a levelling assistant and/or
0-4% by weight of a thixotropic agent and/or a flow modifier.

2. The adhesive system of claim 1, comprising:
85-93% by weight of an epoxy casting resin,
4.5-12% by weight of a polyhydric alcohol,
0.7-1.0% by weight of S-benzylthiolanium hexafluoroantimonate and
0.3-0.6% by weight of an adhesion promoter and/or
0-1.5% by weight of a levelling assistant and/or
0-2.0% by weight of a thixotropic agent and/or a flow modifier.

3. The adhesive system of claim 1 or 2, wherein the epoxy resin is bis(3,4-epoxycyclohexylmethyl) adipate and the polyhydric alcohol is 3(4),8(9)-bis-(hydroxymethyl)tricyclo[5.2.1.0^{2,6}]decane.

4. The use of the adhesive system of one of the above claims for forming glued bonds with dimensional tolerances in the µm and sub-µm region.

## Revendications

1. Système d'adhésif à un composant, thermiquement durcissable, qui comprend les composants suivants:
de 60 à 98 % en poids d'une résine époxy de coulée,
de 2 à 30 % en poids d'un alcool polyfonctionnel ou d'un sucre,
de 0,2 à 2,0 % en poids d'hexafluoroantimonate de S-benzylthiolanium, qui sert d'initiateur thermique,
de 0,2 à 2,0 % en poids d'un agent de renforcement de l'adhérence et/ou
de 0 à 3,0 % en poids d'un agent auxiliaire d'écoulement et/ou
de 0 à 4 % en poids d'un agent thixotropique et/ou d'un agent de modification de l'écoulement.

2. Système d'adhésif selon la revendication 1, qui comprend les composants suivants:
de 85 à 93 % en poids d'une résine époxy de coulée,
de 4,5 à 12 % en poids d'un alcool polyfonctionnel,
de 0,7 à 1,0 % en poids d'hexafluoroantimonate de S-benzylthiolanium et
de 0,3 à 0,6 % en poids d'un agent de renforcement de l'adhérence et/ou
de 0 à 1,5 % en poids d'un agent auxiliaire d'écoulement et/ou
de 0 à 2,0 % en poids d'un agent thixotropique et/ou d'un agent de modification de l'écoulement.

3. Système d'adhésif selon la revendication 1 ou 2, dans lequel la résine d'époxy, l'adipate de bis(3,4-époxycyclohexylméthyle) et l'alcool polyfonctionnel 3(4),8(9)-bis(hydroxyméthyl)-tricyclo[5.2.1.0^{2,6}]décane.

4. Utilisation du système d'adhésif selon l'une des revendications précédentes pour la formation de collages avec des tolérances dimensionnelles dans la plage du µm ou inférieure au µm.
